# EUROPEAN PATENT APPLICATION

(11) **EP 4 811 444 A1**
(43) Date of publication of application: **23.09.2026**
(21) Application number: 24890701.6
(22) Date of filing: 13.11.2024
(51) Int. Cl.: H01M 4/36

(54) **COMPOSITE MATERIAL FOR SECONDARY LITHIUM-ION BATTERY, PREPARATION METHOD THEREFOR AND USE THEREOF**

(30) Priority: 14.11.2023 CN 202311513274
(71) Applicant: Novusilicon Corporation, Changzhou, Jiangsu 213149 (CN)
(72) Inventor: WU, Xindi, Changzhou, Jiangsu 213149 (CN); REN, Chunlei, Changzhou, Jiangsu 213149 (CN)
(74) Representative: Reitstötter Kinzebach
(86) International application number: PCT/CN2024/131713
(87) International publication number: WO 2025/103346

(57) **Abstract**

Disclosed in the present invention are a composite material for a secondary lithium-ion battery and a preparation method therefor. The composite material comprises: a porous matrix, hydrogen-containing silicon dispersed in the porous matrix, and a shell layer coating the outer surface of the porous matrix. The present invention further relates to a negative electrode sheet including the composite material, and a secondary lithium-ion battery including same. In the present invention, hydrogen-containing silicon is uniformly dispersed in the composite material, thus solving the dispersion problem of silicon and mitigating the volume effect of silicon during charging and discharging; and Si-H bonds in the hydrogen-containing silicon can effectively improve the structural stability of the material during charging and discharging, thereby prolonging the cycle life of a battery. The preparation method for a composite material for a secondary lithium-ion battery in the present invention is simple and easy to operate, and can be used for batch production.

## Description

### CROSS REFERENCE TO RELATED APPLICATIONS

This application claims priority to Chinese Patent Application No. 202311513274.6, titled "COMPOSITE MATERIAL FOR SECONDARY LITHIUM-ION BATTERY, PREPARATION METHOD THEREFOR AND USE THEREOF", filed on November 14, 2023, the content of which is expressly incorporated herein by reference in its entirety.

### TECHNICAL FIELD

The present invention relates to the field of battery technology, and in particular, to a composite material for a secondary lithium-ion battery, and a preparation method and use thereof.

### BACKGROUND

Lithium-ion batteries are one of the most widely used secondary battery systems. Compared with other rechargeable batteries such as nickel-cadmium batteries and nickel-metal hydride batteries, lithium-ion batteries have the characteristics of high energy density, high operating voltage, limited self-discharge, and low maintenance requirements. However, commercial graphite negative electrodes have a theoretical specific capacity of only 372 mAhg⁻¹, which cannot meet the increasing demands for energy density, operational reliability, and system integration in portable electronic devices, electric vehicles, and energy storage applications.

Among all potential negative electrode materials for lithium-ion batteries, silicon is one of the most promising candidate materials to replace graphite for the following reasons: (1) silicon has the highest gravimetric capacity (4200 mAhg⁻¹) and volumetric capacity (9786 mAhcm⁻³); (2) the average discharge voltage of Si is about 0.4 V, which achieves a good balance between maintaining a reasonable open-circuit voltage and avoiding adverse lithium plating processes; and (3) silicon has abundant reserves (the second most abundant element in the earth's crust), offering potential low cost, environmental friendliness and non-toxicity.

However, the lithiation and delithiation processes of silicon are accompanied by drastic volume expansion and contraction (approximately 360% volume change), generating significant stress and causing a series of severe impacts on the structure: (1) the structural integrity of the electrode is disrupted during repeated charge-discharge cycles; (2) interfacial stress causes the detachment of the electrode from the current collector; (3) the solid electrolyte interphase (SEI) layer undergoes continuous formation, fracture, and reformation, leading to continuous consumption of lithium ions. These processes act synergistically to accelerate electrode collapse and capacity fade. Furthermore, the poor intrinsic electronic conductivity of silicon also results in sluggish electrochemical kinetics.

The silicon nanotechnology can effectively mitigate the impacts of the aforementioned issues. CN 116454256A discloses a method for preparing a silicon-carbon composite material, which involves the direct in-situ compositing of nano-silicon and nano-carbon, followed by coating with a carbon material layer; and micrometer-scale silicon-carbon composite materials are obtained by slurry preparation and spray granulation. High-temperature treatment pyrolyzes binders or other impurities in the slurry, creating pores that provide expansion space for silicon. Conductive carbon enhances the material's conductivity, which is beneficial for electrochemical performance.

The nanostructuring of silicon can effectively alleviate the impact of volume expansion on the electrode. However, the dispersion of nano-silicon particles within the carbon material still faces significant challenges. The agglomeration of nano-silicon particles can still lead to volume expansion effects, preventing the full utilization of the advantages of nano-silicon.

### SUMMARY

The present invention provides a composite material for a secondary lithium-ion battery and a preparation method and use thereof, aiming to address the challenges faced by nano-silicon in secondary lithium-ion batteries.

In one aspect, the present invention relates to a composite material for a secondary lithium-ion battery. The composite material comprises: a porous matrix, hydrogen-containing silicon dispersed within the porous matrix, and a shell layer coating the outer surface of the porous matrix.

In one embodiment, in the composite material, based on the total weight of the composite material, the hydrogen content in the hydrogen-containing silicon is 0.01-10 wt%, preferably 0.03-5 wt%, more preferably 0.09-3 wt%.

In another aspect, the present invention relates to a method for preparing the composite material of the present invention, comprising the steps of: providing a porous matrix; forming hydrogen-containing silicon dispersed within the porous matrix by a CVD deposition process and/or a liquid impregnation process; and coating the outer surface of the porous matrix having the hydrogen-containing silicon dispersed therein to form a shell layer.

In yet another aspect, the present invention relates to a negative electrode sheet comprising the composite material of the present invention.

In yet another aspect, the present invention relates to a lithium-ion secondary battery comprising the negative electrode sheet of the present invention.

### BRIEF DESCRIPTION OF THE DRAWINGS

FIG. 1: (a) the infrared spectrum of the composite material sample of Example 1; (b) the infrared spectrum of the composite material sample of Example 2; (c) the infrared spectrum of the composite material sample of Example 3; (d) the infrared spectrum of the composite material sample of Example 4; (e) the infrared spectrum of the composite material sample of Example 5; (f) the infrared spectrum of the composite material sample of Example 6; (g) the infrared spectrum of the composite material sample of Example 7.
FIG. 2: the XRD pattern of the composite material sample of Example 1.
FIG. 3: (a) the SEM image of the composite material sample of Example 1; (b) the TEM image of the composite material sample of Example 1.
FIG. 4: the charge-discharge curve of a coin-type half-cell assembled using the negative electrode sheet prepared from the composite material sample of Example 1.
FIG. 5: the cycle life curves of coin-type full-cells assembled using the negative electrode sheets prepared from the composite material samples of Examples 1-7.
FIG. 6: the cycle life curve of a coin-type full-cell assembled using the negative electrode sheet prepared from the composite material sample of Example 1.
FIG. 7: the thickness expansion curve of a coin-type full-cell assembled using the negative electrode sheet prepared from the composite material sample of Example 1.

### DETAILED DESCRIPTION

### General Definitions and Terminology

Unless otherwise indicated, all publications, patent applications, patents, and other references mentioned herein are incorporated by reference in their entirety.

Unless otherwise defined, all technical and scientific terms used herein have the same meaning as commonly understood by one of ordinary skill in the art. In the event of any conflict, the definitions provided in this specification shall govern.

Unless otherwise stated, all percentages, parts, ratios, and the like are by weight.

Where a quantity, concentration, or other value or parameter is expressed as a range, preferred range, or as upper and lower preferred values, or as a specific value, it is to be understood that all ranges formed by any pair of an upper range limit or preferred value with any lower range limit or preferred value are specifically disclosed, whether or not such ranges are separately disclosed. Unless otherwise stated, when a numerical range is recited herein, the range is intended to include the endpoints thereof and all integers and fractions within the range. The scope of the present invention is not limited to the specific values recited when defining a range.

When a numerical value or range endpoint is described herein, it is to be understood that the disclosure includes the specific value or endpoint recited.

The term "comprising" and synonymous terms such as "including", "containing" and "having" are open-ended and do not exclude additional, unrecited elements, steps, or components. The term "consisting of" excludes any element, step, or component not specified. The term "consisting essentially of" limits the scope to the specified elements, steps, or components, plus optional elements, steps, or components that do not materially affect the basic and novel characteristics of the claimed subject matter. It is to be understood that the term "comprising" encompasses the terms "consisting essentially of" and "consisting of."

Unless otherwise stated, the term "combinations thereof" refers to a multi-component mixture of the stated elements, e.g., a mixture of two, three, four, and up to the maximum possible number of components.

Furthermore, where a component or element of the present invention is recited without a preceding quantitative indicator, such recitation implies no limitation on the number of occurrences (or presence) of that component or element. Therefore, it should be construed to include one or at least one, and the singular form of the component or element also includes the plural, unless the context clearly indicates the singular.

As used herein, the term "optional" or "optionally" means that the subsequently described event or circumstance may or may not occur, and that the description includes instances where said event or circumstance occurs and instances where it does not.

As used herein, the term "one or more" or "at least one" refers to one, two, three, four, five, six, seven, eight, nine, or more.

"Carbon" refers to a material or substance consisting essentially of carbon. Examples of carbon materials include, but are not limited to, activated carbon, pyrolytic carbon, hard carbon, graphite, and other allotropes of carbon.

"Carbonizing," "pyrolyzing," "carbonization," and "pyrolysis" all refer to the process of heating a carbon-containing substance in an inert atmosphere (e.g., argon or nitrogen) or under vacuum at a pyrolysis soak temperature, such that the target material collected at the end of the process is primarily carbon. "Pyrolyzed" refers to a material or substance (e.g., a carbon material) that has undergone a pyrolysis process.

"Soak temperature" refers to the furnace temperature maintained during a portion of the process in which the temperature is held substantially constant (i.e., neither raised nor lowered). For example, the pyrolysis soak temperature refers to the relatively constant furnace temperature during pyrolysis, and the activation soak temperature refers to the relatively constant furnace temperature during activation.

"Pore structure" refers to the surface architecture of the internal pores within a carbon material (e.g., an activated carbon material). The composition of the pore structure includes pore size, pore volume, surface area, density, pore size distribution, and pore length. Typically, the pore structure of a porous carbon material includes micropores, mesopores, and macropores.

"Mesopore" refers to a pore having a pore size of 2-50 nm; "micropore" refers to a pore having a pore size of less than 2 nm; and "macropore" refers to a pore having a pore size of greater than 50 nm. A mesoporous carbon material has mesopores accounting for 50% of the total pore volume or more. A microporous carbon material has micropores accounting for 50% of the total pore volume or more.

"Surface area" refers to the total specific surface area of a substance measurable by the BET technique. Typically, the surface area is expressed in units of m²/g. The BET technique uses an inert gas (e.g., nitrogen) to measure the amount of gas adsorbed onto the material and is commonly used in the art to determine the accessible surface area of a material.

"Composite material" refers to a composition comprising multiple (two or more) different chemical substances within the same particle, such as a particle comprising a porous carbon material and a silicon material.

"Allotrope" refers to materials consisting of the same single chemical element but capable of existing in different forms. C60, graphene, diamond, hard carbon, soft carbon, graphite, and carbon nanotubes are all examples of carbon allotropes. "Hard carbon" refers to a non-graphitizable carbon material. At high temperatures (generally 1500-2200°C), hard carbon remains substantially amorphous, whereas soft carbon undergoes crystallization and become graphitized.

"Coulombic efficiency" refers to the ratio of discharge capacity to charge capacity of a lithium-ion energy storage device. The coulombic efficiency is expressed as a percentage or fraction (e.g., 99%=0.99).

### Composite Material for Secondary Lithium-ion Batteries

In one aspect, the present invention provides a composite material for a secondary lithium-ion battery, comprising: a porous matrix, hydrogen-containing silicon dispersed within the porous matrix, and a shell layer coating the outer surface of the porous matrix.

### Porous Matrix

The porous matrix of the present application possesses a suitable pore structure. This facilitates the uniform dispersion of silicon particles within the internal pores of the porous matrix to form nano-silicon particles, thereby avoiding the potential volume expansion effect caused by the agglomeration of silicon particles. Consequently, the advantages of nano-silicon particles are fully utilized, improving the performance of the composite material.

In the present invention, the porous matrix can encompass various materials. The porous matrix may include, but is not limited to: porous carbon, porous polymeric materials, porous ceramic materials, porous metallic materials, or combinations thereof.

In preferred embodiments, the porous matrix material primarily comprises carbon, such as hard carbon. Other allotropes of carbon are also contemplated, for example, graphite, amorphous carbon, diamond, C60, carbon nanotubes (e.g., single-walled and/or multi-walled), graphene, and/or carbon fibers. Porosity can be introduced into the carbon material by various means. For instance, porosity in the carbon material can be achieved by tailoring polymer precursors and/or processing conditions to produce a porous carbon material (described in detail in a subsequent section).

In other embodiments, the porous matrix may comprise a polymeric material. Polymers include, but are not limited to, at least one of polyaniline, polyether, polytetrafluoroethylene, polyethylene oxide, chitosan, polyvinyl alcohol, polyacrylamide, microcrystalline cellulose, polystyrene, 3,4-ethylenedioxythiophene, styrene sulfonate, polyethyleneimine, polyurethane, aqueous polyurethane, polyimide, hydrated aramid nanofibers, polydimethylsiloxane, acrylonitrile-butadiene-styrene, polyethersulfone, polycarbonate, and polyacrylonitrile. The polymers also include resin materials, such as: epoxy resin, polyester resin, acrylic resin, phenolic resin, FEVE fluororesin, ETFE fluororesin, phthalonitrile resin, etc. The polymers may also include biomass materials: lignin, coconut shell, moso bamboo, fructose, sucrose, maltose, glucose, cellulose, starch, etc.

The porous matrix materials include porous ceramic materials, including but not limited to porous magnesium oxide, porous aluminum oxide, porous beryllium oxide, porous zirconium oxide, porous tin oxide, porous silica, porous silicon nitride, porous aluminum nitride, porous boron nitride, porous titanium nitride, and porous silicon carbide.

The porous matrix materials also include porous metals, including but not limited to porous aluminum, porous steel, porous nickel, porous chromium-nickel-iron alloy, porous titanium, porous copper, porous brass, porous gold, porous silver, porous germanium, etc.

In the present invention, the preparation of porous materials includes, but is not limited to, the following methods: emulsification, micelle creation, gasification dissolution followed by solvent removal (e.g., lyophilization), axial compaction and sintering, gravity sintering, powder rolling and sintering, isostatic compaction and sintering, metal spraying, metal coating and sintering, metal injection molding and sintering, etc. Methods for preparing porous materials may also include other pathways for producing porous polymeric materials, including producing porous gels, such as freeze-dried gels, etc.

The particle size of silicon particles dispersed within the pores of the porous matrix is influenced by the pore size distribution of the porous matrix. A suitable pore size distribution of the porous matrix helps promote the formation of nano-silicon particles. The porous matrix may comprise 20%-90% micropores, 10%-50% mesopores, and 0-30% macropores. The total pore volume of the porous matrix may be 0.1-2.5 cm³/g, preferably 0.5-1.2 cm³/g.

In some embodiments, the porous carbon has different pore size distributions, comprising 20% micropores, 50% mesopores and 30% macropores, with a total pore volume of 1.2 cm³/g. In certain embodiments, it comprises 25% micropores, 45% mesopores, and 30% macropores, with a total pore volume of 1.0 cm³/g. In certain embodiments, it comprises 30% micropores, 45% mesopores, and 25% macropores, with a total pore volume of 0.9 cm³/g. In certain embodiments, it comprises 35% micropores, 40% mesopores, and 25% macropores, with a total pore volume of 0.8 cm³/g. In certain embodiments, it comprises 40% micropores, 40% mesopores, and 20% macropores, with a total pore volume of 0.7 cm³/g. In certain embodiments, it comprises 50% micropores, 35% mesopores, and 15% macropores, with a total pore volume of 0.6 cm³/g. In certain embodiments, it comprises 60% micropores, 30% mesopores, and 10% macropores, with a total pore volume of 0.5 cm³/g. In certain embodiments, it comprises 70% micropores, 25% mesopores, and 5% macropores, with a total pore volume of 0.4 cm³/g. In certain embodiments, it comprises 80% micropores, 18% mesopores, and 2% macropores, with a total pore volume of 0.2 cm³/g. In certain embodiments, it comprises 90% micropores and 10% mesopores, with a total pore volume of 0.1 cm³/g.

A suitable pore volume of the porous matrix is beneficial for increasing the silicon content in the composite material, thereby improving the performance of the corresponding product, such as specific charge capacity. The BET specific surface area of the porous matrix may be 1000-2500 m²/g, for example, 1900-2000 m²/g, 1000-1200 m²/g, 1500-1600 m²/g, 2200-2500 m²/g, etc.

A suitable particle size distribution of the porous matrix is beneficial for increasing the silicon content in the composite material, thereby improving the performance of the corresponding product. The D50 particle size of the porous matrix may be 1-30 µm, preferably 1-20 µm, for example, 5-15 µm, 5-20 µm, 10-25 µm, 5-25 µm, 10-30 µm, etc. The D100 particle size of the porous matrix may be 5-80 µm, preferably 5-50 µm, for example, 10-20 µm, 20-40 µm, 30-50 µm, 40-60 µm, 50-70 µm, 60-80 µm, etc.

In some embodiments, the porous carbon has different particle size distributions: a D50 of 1-10 µm and a D100 of 5-10 µm. In certain embodiments, the particle size distribution has a D50 of 5-15 µm and a D100 of 10-20 µm. In certain embodiments, the particle size distribution has a D50 of 5-20 µm and a D100 of 20-40 µm. In certain embodiments, the particle size distribution has a D50 of 10-25 µm and a D100 of 30-50 µm. In certain embodiments, the particle size distribution has a D50 of 5-25 µm and a D100 of 40-60 µm. In certain embodiments, the particle size distribution has a D50 of 10-30 µm and a D100 of 50-70 µm. In certain embodiments, the particle size distribution has a D50 of 15-30 µm and a D100 of 60-80 µm.

A suitable oxygen content of the porous matrix helps improve the electrochemical performance of the product. Excessively high oxygen content in the porous matrix may lead to a decrease in the first-cycle Coulombic efficiency of the battery. The oxygen content of the porous matrix may be 0.01-0.6 mmol/g, for example, 0.01-0.4 mmol/g, 0.1-0.3 mmol/g, 0.2-0.5 mmol/g, 0.3-0.6 mmol/g, etc.

The tap density of the porous matrix may be 0.2-0.6 g/cm³, for example, 0.2 g/cm³, 0.3 g/cm³, 0.4 g/cm³, 0.5 g/cm³, 0.6 g/cm³. In certain embodiments, the composite material for the secondary lithium-ion battery has a tap density of 0.8 g/cm³, and the porous matrix has a tap density of 0.4 g/cm³. In certain embodiments, the composite material for the secondary lithium-ion battery has a tap density of 1.2 g/cm³, and the porous matrix has a tap density of 0.5 g/cm³. In certain embodiments, the composite material for the secondary lithium-ion battery has a tap density of 1.4 g/cm³, and the porous matrix has a tap density of 0.6 g/cm³. In certain embodiments, the composite material for the secondary lithium-ion battery has a tap density of 2 g/cm³, and the porous matrix has a tap density of 0.6 g/cm³.

### Hydrogen-Containing Silicon

In the present application, silicon is uniformly dispersed within the internal pores of the porous matrix to form nano-silicon (i.e., nano-silicon particles), while the outer surface of the porous matrix is substantially free of silicon distribution. This facilitates the material in fully exploiting the advantages of nano-silicon. In the present application, for the silicon dispersed within the porous matrix, a portion of the Si-H bonds are retained; therefore, the silicon dispersed within the porous matrix is also referred to as hydrogen-containing silicon.

The hydrogen-containing silicon in the present application refers to: all the nano-silicon dispersed within the porous matrix. In the hydrogen-containing silicon herein, at least a portion of the nano-silicon particles are nano-silicon particles with Si-H bonds.

The presence of Si-H bonds in the hydrogen-containing silicon can effectively improve the stability of the composite material during charge and discharge cycles, prolonging the cycle life of the battery. The Si-H bonds in the hydrogen-containing silicon can be determined by any means known in the art, including but not limited to infrared spectroscopy. The infrared spectrum of the composite material of the present application has a vibrational peak at 625-640 cm⁻¹. The infrared spectrum of the composite material may also has vibrational peaks at one or more of the following positions: 845-885 cm⁻¹, 1990-2010 cm⁻¹

"Hydrogen content in hydrogen-containing silicon" refers to: the percentage, relative to the total weight of the composite material, of the total weight of the hydrogen present in the retained Si-H bonds within the hydrogen-containing silicon. The amount of Si-H bonds present in the hydrogen-containing silicon is positively correlated with the hydrogen content in the hydrogen-containing silicon. Factors such as the structure of the porous matrix and the process of dispersing silicon within the porous matrix influence the amount of Si-H bonds present in the hydrogen-containing silicon and the hydrogen content in the hydrogen-containing silicon. A suitable hydrogen content in the hydrogen-containing silicon helps improve the electrical performance of the product, for example, improving the capacity retention of the battery. Based on the total weight of the composite material, the hydrogen content in the hydrogen-containing silicon may be 0.01-10 wt%, preferably 0.3-5 wt%, more preferably 0.9-3 wt%, for example, 0.01 wt%, 0.1 wt%, 0.3 wt%, 0.5 wt%, 0.9 wt%, 1.0 wt%, 1.1 wt%, 1.2 wt%, 1.3 wt%, 1.4 wt%, 1.5 wt%, 1.6 wt%, 1.7 wt%, 1.8 wt%, 1.9 wt%, 2.0 wt%, 2.1 wt%, 2.2 wt%, 2.3 wt%, 2.4 wt%, 2.5 wt%, 2.6 wt%, 2.7 wt%, 2.8 wt%, 2.9 wt%, 3.0 wt%, 5.0 wt%, 10.0 wt%, etc. The hydrogen content in the hydrogen-containing silicon can be determined by any available method in the art; for example, the hydrogen content C_{H} in the hydrogen-containing silicon can be calculated by fitting the infrared absorption peak in the wagging mode region of the infrared spectrum.

The ratio of silicon dispersed within the porous matrix to the porous matrix also affects the performance of the composite material. A suitable content of silicon dispersed within the porous matrix can impart favorable electrical properties (such as excellent specific charge capacity) to the product, while also preserving some pores within the porous matrix, leaving space for subsequent expansion of the silicon, thereby avoiding cracking or even pulverization of the composite material due to silicon's volume expansion.

Based on the total weight of the composite material, the silicon content of the composite material may be 5-90 wt%, preferably 15-70 wt%, more preferably 30-65 wt%, for example, 5 wt%, 10 wt%, 15 wt%, 20 wt%, 25 wt%, 30 wt%, 35 wt%, 40 wt%, 41 wt%, 42 wt%, 43 wt%, 44 wt%, 45 wt%, 46 wt%, 47 wt%, 48 wt%, 49 wt%, 50 wt%, 55 wt%, 60 wt%, 65 wt%, 70 wt%, 75 wt%, 80 wt%, 85 wt%, 90 wt%, etc. It can be understood that in the composite material, if components other than the hydrogen-containing silicon dispersed within the porous matrix (such as the porous matrix, the shell layer) do not contain Si, the silicon content in the composite material is equivalent to the content of silicon dispersed within the porous matrix.

A suitable particle size of the hydrogen-containing silicon is beneficial for improving the performance of the composite material. The particle size of the hydrogen-containing silicon is in the range of 0.1-60 nm, preferably 0.1-20 nm, more preferably 1-5 nm.

The morphology of the hydrogen-containing silicon can be crystalline silicon or amorphous silicon. In certain embodiments, the hydrogen-containing silicon comprises hydrogen-containing crystalline silicon. In certain embodiments, the hydrogen-containing silicon comprises hydrogen-containing polycrystalline silicon. In certain embodiments, the hydrogen-containing silicon comprises nano-hydrogen-containing polycrystalline silicon. In certain other embodiments, the hydrogen-containing silicon comprises hydrogen-containing amorphous silicon. In certain other embodiments, the hydrogen-containing silicon comprises both hydrogen-containing crystalline silicon and hydrogen-containing amorphous silicon.

The crystallinity of silicon in the hydrogen-containing silicon can be determined by any method in the art, for example, by electrochemical curve analysis. For a tested sample obtained from the composite material, the plateau in its charge curve at 0.4-0.5V, and the corresponding characteristic peak in the DQ/DV curve at 0.4-0.5V, are related to the crystallinity of the hydrogen-containing silicon. A higher proportion of crystalline silicon in the hydrogen-containing silicon results in a more pronounced plateau in the charge curve at 0.4-0.5V and a stronger intensity of the characteristic peak in the DQ/DV curve at 0.4-0.5V.

### Shell Layer Coating the Outer Surface of the Porous Matrix

The outer surface of the porous matrix further comprises a dense shell layer, which serves as the outer layer of the composite material. The shell layer coating the outer surface of the porous matrix not only prevents the highly active nano-hydrogen-containing silicon within the pores of the porous matrix from oxidizing or spontaneously combusting in air, but also ensures that during the use of the composite material, the porous matrix and the hydrogen-containing silicon within it do not directly contact the electrolyte, which is beneficial for forming a stable SEI film.

The shell layer can be formed by subjecting the porous matrix with dispersed hydrogen-containing silicon to a reaction treatment, or by attaching an additional material to the surface of the porous matrix.

The components of the shell layer may include, but are not limited to: amorphous carbon, graphene, carbon nanotubes, conductive polymers, titanium carbide, aluminum oxide, aluminum nitride, a carbide of silicon, a nitride of silicon, an oxide of silicon (e.g., silica), an oxynitride of silicon, or a combination thereof. In certain embodiments, the shell layer of the composite material of the present invention is a carbon shell.

The shell layer may be a single layer or multiple layers. For any layer within the shell layer, it is not limited to a single component as mentioned; it can be a combination of several substances.

A suitable thickness of the shell layer helps the shell layer to fully perform its function. The thickness of the shell layer may be 1-1000 nm. In some embodiments, the shell layer thickness of the composite material for the secondary lithium-ion battery is 1-10 nm. In certain embodiments, the shell layer thickness of the composite material for the secondary lithium-ion battery is 10-50 nm. In certain embodiments, the shell layer thickness of the composite material for the secondary lithium-ion battery is 50-100 nm. In certain embodiments, the shell layer thickness of the composite material for the secondary lithium-ion battery is 100-500 nm. In certain embodiments, the shell layer thickness of the composite material for the secondary lithium-ion battery is 500-1000 nm.

It should be understood that the phrase "shell layer coating the outer surface of the porous matrix" as used herein does not imply that the shell layer material is located solely on the exterior side of the porous matrix. For example, the shell layer material may penetrate into pores of the porous matrix near its outer surface. As another example, the shell layer can be formed by reacting the outer portion of the porous matrix in which the nano-silicon is dispersed.

It should also be understood that there may be a distinct interface between the shell layer and the porous matrix as described herein. Alternatively, there may be no distinct interface between the shell layer and the porous matrix as described herein. For example, there may be an interfacial region of a certain thickness between the shell layer and the porous matrix.

It should also be understood that the thickness of the shell layer described herein may be uniform or may vary at different locations.

### Preparation Method

In another aspect, the present invention provides a method for preparing the aforementioned composite material for the secondary lithium-ion battery, comprising:
providing a porous matrix;
forming hydrogen-containing silicon dispersed within the porous matrix by a CVD deposition process and/or a liquid impregnation process; and
coating the outer surface of the porous matrix having the hydrogen-containing silicon dispersed therein to form a shell layer.

### Provision of the Porous Matrix

The method of providing the porous matrix is not particularly limited herein; it can be obtained commercially or prepared by any preparation method known in the art.

As an example, for porous carbon, porosity can be introduced into a carbon material by various means to form porous carbon. Porosity in the carbon material can be controlled by tailoring polymer precursors and/or processing conditions during preparation to produce the target porous carbon.

In the present invention, the preparation of porous materials includes, but is not limited to, the following methods: emulsification, micelle creation, gasification dissolution followed by solvent removal (e.g., lyophilization), axial compaction and sintering, gravity sintering, powder rolling and sintering, isostatic compaction and sintering, metal spraying, metal coating and sintering, metal injection molding and sintering, and the like.

As an example, for porous polymeric materials, their preparation methods may include, but are not limited to: preparing porous gels by freeze-drying.

### Formation of the Hydrogen-Containing Silicon

The silicon can be dispersed into the pores of the porous matrix by any method in the art to form hydrogen-containing silicon dispersed within the porous matrix. The retention of Si-H bonds can be achieved by controlling the dispersion process of silicon (e.g., temperature), thereby effectively improving the stability of the composite material during charge and discharge cycles and prolonging the cycle life of the battery.

The dispersion process of silicon can be carried out by any method in the art, including but not limited to the CVD deposition process and liquid impregnation process. Suitable parameters during the dispersion process contribute to obtaining the desired composite material.

Forming hydrogen-containing silicon dispersed within the porous matrix by the CVD deposition process includes: placing the porous matrix in a reaction vessel, and introducing a protective gas into the reaction vessel; heating the reaction vessel to a reaction temperature; and introducing a silicon-containing gas into the reaction vessel for deposition within the porous matrix. The heating rate for the reaction vessel may be 1-10°C/min, for example, 1°C/min, 2°C/min, 3°C/min, 4°C/min, 5°C/min, 6°C/min, 7°C/min, 8°C/min, 9°C/min, 10°C/min, etc. The reaction temperature may be 400-600°C, for example, 400°C, 405°C, 420°C, 450°C, 480°C, 500°C, 550°C, 600°C, etc. The flow rate of the protective gas may be 5-30 L/min, for example, 5 L/min, 10 L/min, 15 L/min, 20 L/min, 23 L/min, 25 L/min, 30 L/min, etc. The total flow rate of the silicon-containing gas may be 10-40 L/min, for example, 10 L/min, 15 L/min, 20 L/min, 25 L/min, 30 L/min, 35 L/min, 40 L/min, etc. The deposition time may be 5-20 hours, for example, 5 hours, 6 hours, 10 hours, 15 hours, 20 hours, etc.

In the CVD deposition process, the silicon-containing gas may include: dichlorosilane, SiₙH₂ₙ₊₂ silane, or a combination thereof, wherein n is an integer selected from 1-3. The silicon-containing gas may preferably include: dichlorosilane, monosilane, disilane, trisilane, or a combination thereof.

In the CVD deposition process, the reaction vessel may be designed as: a fluidized bed reactor, tube furnace, bell furnace, pit furnace, elevator kiln, rotary kiln, box kiln, or other suitable reactor types. In preferred embodiments, the reaction is carried out under conditions providing uniform gas phase entry, for example: a reactor in which the feedstock is fluidized, or stirred by other means to provide uniform gas entry.

Preferably, in provision of the composite material for the secondary lithium-ion battery by the present invention, the porous carbon particles are placed under an inert atmosphere and subjected to high temperature, fully contacted with a silicon-containing gas, to achieve uniform deposition of silicon via chemical vapor deposition, thereby forming hydrogen-containing silicon in the pores of the porous carbon. Specifically: the porous carbon is placed in a reaction vessel, and nitrogen or argon is introduced as a protective gas at a flow rate of 1-50 L/min. The reactor is heated to 400-600°C at a heating rate of 1-10°C/min. The silicon-containing gas is then introduced into the reaction vessel for deposition onto the porous carbon. Preferably, the temperature may be 400-450°C, 450-500°C, 500-550°C, 550-600°C, or 500-600°C. The silicon-containing gas is introduced into the reaction vessel together with the inert gas, wherein the content of the silicon-containing gas may be 0.1-1%, 1%-10%, 10%-20%, 20%-30%, 30%-40%, or 40%-50%. The silicon-containing gas may also be any gas of one or more silanes of the general formula SiₙH₂ₙ₊₂ (where n is an integer selected from 1-3). For example, the silicon-containing gas may be monosilane, disilane, or trisilane. The reaction vessel may be designed as: a fluidized bed reactor, tube furnace, bell furnace, pit furnace, elevator kiln, rotary kiln, box kiln, or other suitable reactor types. In a preferred embodiment, the porous carbon particles are processed under conditions providing uniform gas phase entry, for example, a reactor in which the porous carbon particles are fluidized, or stirred by other means to provide uniform gas entry.

Forming hydrogen-containing silicon dispersed within the porous matrix by a liquid impregnation process includes: uniformly mixing the porous matrix and a silane liquid, performing carbonization and reduction by high temperature. The silane liquid includes: trichlorosilane, SiₙH₂ₙ₊₂ silane, or a combinations thereof, wherein n is an integer selected from 4-10. In certain embodiments, the porous matrix to be impregnated or otherwise impregnated with silicon is porous carbon. The porous carbon to be impregnated or otherwise impregnated with silicon may comprise various allotropes of carbon. For this purpose, the porous carbon to be impregnated or otherwise impregnated with silicon may include graphite, nano-graphite, graphene, nano-graphene, carbon black, carbon nanowires, carbon nanotubes, and the like, and combinations thereof.

In certain embodiments, the carbon scaffold impregnated or otherwise impregnated with silicon is removed to obtain a templated silicon material with desired dimensional characteristics. The removal of the scaffold carbon can be achieved by methods known in the art, for example, by thermo-chemical activation under certain conditions where the silicon does not undergo undesirable changes in its electrochemical properties. Alternatively, if the scaffold is a porous polymer or other material soluble in a suitable solvent, the scaffold can be removed by dissolution.

### Formation of the Shell Layer

The formation of the shell layer can be achieved by coating the outer surface of the porous matrix having the hydrogen-containing silicon dispersed therein. Coating the shell layer on the surface of the porous matrix having the hydrogen-containing silicon dispersed therein can prevent the highly active hydrogen-containing silicon from being oxidized upon exposure to air. Meanwhile, during the use of the composite material, it can also reduce the direct contact between the porous matrix and the hydrogen-containing silicon within it and the electrolyte, facilitating the formation of a stable SEI film on the surface.

The coating method is not particularly limited herein. The outer surface of the porous matrix can be coated by reactive coating, adhesive coating, or a combination of reactive and adhesive coating. Other methods capable of forming a shell layer on the surface of the porous matrix having the hydrogen-containing silicon dispersed therein can also be employed.

Reactive coating refers to forming a shell layer via a reaction treatment to achieve coating. For example, a shell layer may be formed by subjecting the porous matrix having the hydrogen-containing silicon dispersed therein to a reaction treatment. Specifically, the coating can be achieved by reaction treatments such as partial oxidation, nitridation, or carbonization of the hydrogen-containing silicon. In certain embodiments, the shell layer material is silica, which can be formed by: placing the porous matrix having the hydrogen-containing silicon dispersed therein in an oxidizing atmosphere for heat treatment, i.e., uniformly generating a silica shell layer on the surface of the porous matrix having the hydrogen-containing silicon dispersed therein via surface oxidation. In these embodiments, the oxidizing atmosphere includes, but is not limited to, one or more of air, oxygen, carbon dioxide, carbon monoxide, water vapor, etc. The heat treatment temperature may be 0-100°C, 100-200°C, 200-300°C, 300-400°C, or 400-500°C.

Adhesive coating refers to attaching a material onto the surface of the porous matrix to form a shell layer.

The outer surface of the porous matrix can be coated by a combination of reactive and adhesive coating. Specific examples are provided below.

In certain embodiments, the shell layer material is carbon. The porous matrix (e.g., porous carbon) having the hydrogen-containing silicon dispersed therein can be contacted with a carbon source precursor, and after heat treatment, a uniform carbon shell layer is generated on the surface of the porous matrix having the hydrogen-containing silicon dispersed therein. Coating methods include chemical vapor deposition (CVD), liquid-phase coating, and solid-phase coating. Using porous carbon as the porous matrix as an example, the various coating methods are described below. In the chemical vapor deposition (CVD) process, the carbon source precursor includes, but is not limited to, one or more of methane, propane, butane, cyclohexane, ethane, propylene, and acetylene, and the like. The coating temperature may be 400-450°C, 450-500°C, 500-550°C, or 550-600°C. In the liquid-phase coating method, the carbon source precursor includes, but is not limited to, one or a combination of several of pitch, polyvinyl alcohol, polyethylene glycol, anthracene, aniline, tannic acid, etc. The mixing ratio range of the liquid carbon source to the porous carbon having the hydrogen-containing silicon dispersed therein is 1:0.5 to 1:10. Uniform mixing is achieved by stirring and ultrasonic dispersion. The carbonization temperature may be 400-450°C, 450-500°C, 500-550°C, or 550-600°C. In the solid-phase coating method, the carbon source precursor includes, but is not limited to, one or a combination of several of glucose, sucrose, biphenyl, vinylpyrrolidone, etc. The carbonization temperature may be 400-450°C, 450-500°C, 500-550°C, or 550-600°C. The carbonization time may be 1 hour to 5 hours. The ratio range of the solid-phase carbon source to the porous carbon having the hydrogen-containing silicon dispersed therein may be 1:0.5 to 1:10.

In certain embodiments, the shell layer material is a metal oxide. The porous carbon having the hydrogen-containing silicon dispersed therein is contacted with a metal oxide precursor, and after heat treatment, a uniform layer of metal oxide shell layer is generated on the surface of the porous carbon having the hydrogen-containing silicon dispersed therein. Coating methods include chemical vapor deposition (CVD), liquid-phase coating, and solid-phase coating. In these embodiments, the shell layer material precursor includes, but is not limited to, one or more of titanate, aluminum phosphate, etc. The heat treatment temperature may be 0-100°C, 100-200°C, 200-300°C, 300-400°C, or 400-500°C.

In one embodiment, the present disclosure provides a method for preparing a composite material for a secondary lithium-ion battery, wherein the matrix is a porous matrix, and the uniform dispersion of silicon in the porous matrix is achieved by contacting the porous matrix with a silicon-containing reactant, with silicon mainly uniformly distributed inside the pores of the porous matrix in the form of hydrogen-containing silicon. The method may comprise the steps of: 1) preparing a porous carbon material as the porous matrix; 2) subjecting the porous matrix to high temperature in a reaction vessel in the presence of a silicon-containing gas for deposition, thereby producing a porous carbon material having the hydrogen-containing silicon uniformly dispersed therein.

In another embodiment, the present disclosure provides a method for preparing a composite material for a secondary lithium-ion battery, wherein the matrix is a porous matrix, the uniform dispersion of silicon in the porous matrix is achieved by contacting the porous matrix with a silicon-containing reactant, and the final coating layer is achieved by contacting the composite with a carbon-containing reactant. For example, the method may comprise the steps of: 1) preparing a porous carbon material as the porous matrix; 2) subjecting the porous matrix to high temperature in a reaction vessel in the presence of a silicon-containing gas for deposition, thereby producing a porous carbon material having the hydrogen-containing silicon uniformly dispersed therein; 3) performing carbon coating via any one of vapor-phase coating, liquid-phase coating, or solid-phase coating.

In yet another embodiment, the present disclosure provides a method for preparing a composite material for a secondary lithium-ion battery, wherein the matrix is a porous matrix, the uniform dispersion of silicon in the porous matrix is achieved by contacting the porous matrix with a silicon-containing reactant, and a silica coating layer is achieved by contacting the composite with an oxygen-containing atmosphere, followed by achieving a carbon coating layer by contacting the composite with a carbon-containing reactant. For example, the method may comprise the steps of: 1) preparing a porous carbon material as the porous matrix; 2) subjecting the porous matrix to high temperature in a reaction vessel in the presence of a silicon-containing gas for deposition, thereby producing a porous carbon material having the hydrogen-containing silicon uniformly dispersed therein; 3) treating the surface of the carbon material having the hydrogen-containing silicon uniformly dispersed therein with an oxidizing atmosphere of any one of air, carbon dioxide, or water vapor to oxidize and passivate, thereby obtaining a silica shell layer; 4) performing carbon coating via any one of vapor-phase coating, liquid-phase coating, or solid-phase coating to obtain a carbon shell layer.

### Performance of the Composite Material for Secondary Lithium-ion Batteries

The composite material of the present invention possesses various advantageous properties and can be used to prepare secondary lithium-ion batteries with excellent performance.

### Physical Properties

The composite material for the secondary lithium-ion battery of the present invention possess suitable physical properties, which is beneficial for preparing a secondary lithium-ion battery with excellent performance.

The composite material for the secondary lithium-ion battery may contain hydrogen-containing silicon in varying proportions. Suitable elemental content in the composite material contributes to improving its properties, particularly its electrical performance.

Based on the total weight of the composite material, the hydrogen content in the hydrogen-containing silicon may be 0.01-10 wt%, preferably 0.3-5 wt%, more preferably 0.9-3 wt%, for example, 0.01 wt%, 0.1 wt%, 0.3 wt%, 0.5 wt%, 0.9 wt%, 1.0 wt%, 1.1 wt%, 1.2 wt%, 1.3 wt%, 1.4 wt%, 1.5 wt%, 1.6 wt%, 1.7 wt%, 1.8 wt%, 1.9 wt%, 2.0 wt%, 2.1 wt%, 2.2 wt%, 2.3 wt%, 2.4 wt%, 2.5 wt%, 2.6 wt%, 2.7 wt%, 2.8 wt%, 2.9 wt%, 3.0 wt%, 5.0 wt%, 10.0 wt%, etc.

Based on the total weight of the composite material, the silicon content of the composite material may be 5-90 wt%, preferably 15-70 wt%, more preferably 30-65 wt%, for example, 5 wt%, 10 wt%, 15 wt%, 20 wt%, 25 wt%, 30 wt%, 35 wt%, 37.9 wt%, 40 wt%, 40.2 wt%, 42.5 wt%, 45 wt%, 46 wt%, 46.1 wt%, 47 wt%, 47.2 wt%, 48 wt%, 49 wt%, 50 wt%, 51 wt%, 52 wt%, 53 wt%, 54 wt%, 55 wt%, 60 wt%, 65 wt%, 70 wt%, 80 wt%, 85 wt%, 90 wt%, etc.

Based on the total weight of the composite material, the carbon content of the composite material may be 10-95 wt%, preferably 30-90 wt%, more preferably 35-85 wt%, for example, 10 wt%, 15 wt%, 20 wt%, 25 wt%, 30 wt%, 35 wt%, 40 wt%, 42.5 wt%, 45 wt%, 46 wt%, 47 wt%, 48 wt%, 49 wt%, 50 wt%, 50.8 wt%, 51 wt%, 51.3 wt%, 51.8 wt%, 52 wt%, 53 wt%, 54 wt%, 55 wt%, 57.3 wt%, 60 wt%, 60.3 wt%, 65 wt%, 70 wt%, 80 wt%, 90 wt%, 95 wt%, etc.

Based on the total weight of the composite material, the oxygen content of the composite material may be 0-3 wt%, for example, 0 wt%, 0.1 wt%, 0.2 wt%, 0.3 wt%, 0.4 wt%, 0.5 wt%, 1 wt%, 1.5 wt%, 2 wt%, 2.5 wt%, 3 wt%, etc.

In certain embodiments, the composite material has a C content of 51.8 wt%, a Si content of 45.0 wt%, an O content of 0.2 wt%, and an H content in the hydrogen-containing silicon of 3.0 wt%. In certain embodiments, the composite material has a C content of 51.3 wt%, a Si content of 46.1 wt%, an O content of 0.2 wt%, and an H content in the hydrogen-containing silicon of 2.4 wt%. In certain embodiments, the composite material has a C content of 50.8 wt%, a Si content of 47.2 wt%, an O content of 0.2 wt%, and an H content in the hydrogen-containing silicon of 1.8 wt%. In certain embodiments, the composite material has a C content of 58.4 wt%, a Si content of 40.2 wt%, an O content of 0.2 wt%, and an H content in the hydrogen-containing silicon of 1.2 wt%. In certain embodiments, the composite material has a C content of 60.3 wt%, a Si content of 37.9 wt%, an O content of 0.3 wt%, and an H content in the hydrogen-containing silicon of 1.5 wt%. In certain embodiments, the composite material has a C content of 57.3 wt%, a Si content of 42.5 wt%, an O content of 0.2 wt%, and an H content in the hydrogen-containing silicon of 0.01 wt%.

The specific surface area of the composite material for the secondary lithium-ion battery of the present invention may vary. The BET specific surface area of the composite material may be 1-10 m²/g, for example, 1 m²/g, 2 m²/g, 3 m²/g, 4 m²/g, 5 m²/g, 6 m²/g, 7 m²/g, 8 m²/g, 9 m²/g, 10 m²/g. The total pore volume of the composite material may be 0.1 cm³/g or less. In certain embodiments, the BET is 1 m²/g and the total pore volume is less than 0.1 cm³/g. In certain embodiments, the BET is 2 m²/g and the total pore volume is less than 0.1 cm³/g. In certain embodiments, the BET is 4 m²/g and the total pore volume is less than 0.1 cm³/g. In certain embodiments, the BET is 6 m²/g and the total pore volume is less than 0.1 cm³/g. In certain embodiments, the BET is 8 m²/g and the total pore volume is less than 0.1 cm³/g. In certain embodiments, the BET is 10 m²/g and the total pore volume is less than 0.1 cm³/g.

In preferred embodiments, the composite material has a relatively uniform size distribution, with upper and lower limits within a preferred range, for example, a particle size distribution D50 of 1-15 µm and D100 of 10-30 µm. In certain embodiments, the composite material comprises the following size distribution: D50 of 5-20 µm, D100 of 20-40 µm. In certain embodiments, the composite material comprises the following size distribution: D50 of 15-25 µm, D100 of 40-60 µm. In certain embodiments, the composite material comprises the following size distribution: D50 of 20-30 µm, D100 of 50-70 µm. In certain embodiments, the composite material comprises the following size distribution: D50 of 25-35 µm, D100 of 60-80 µm. In certain embodiments, the composite material comprises the following size distribution: D50 of 30-40 µm, D100 of 70-90 µm. In certain embodiments, the composite material comprises the following size distribution: D50 of 40-50 µm, D100 of 80-100 µm.

In some embodiments, the XRD pattern of the composite material for the secondary lithium-ion battery exhibits a broad amorphous hump between 24-30°. In some embodiments, it exhibits a sharp characteristic peak at 28°±0.5° with a crystallite size of 5-30 nm. In certain embodiments, the crystallite size is 5 nm. In certain embodiments, the crystallite size is 10 nm. In certain embodiments, the crystallite size is 15 nm. In certain embodiments, the crystallite size is 20 nm. In certain embodiments, the crystallite size is 30 nm.

The tap density of the composite material for the secondary lithium-ion battery of the present invention may be 0.5-2 g/cm³. In some embodiments, the tap density of the composite material for the secondary lithium-ion battery is 0.5 g/cm³, and the tap density of the porous matrix is 0.2 g/cm³. In certain embodiments, the tap density of the composite material for the secondary lithium-ion battery is 0.6 g/cm³, and the tap density of the porous matrix is 0.3 g/cm³. In certain embodiments, the tap density of the composite material for the secondary lithium-ion battery is 0.8 g/cm³, and the tap density of the porous matrix is 0.4 g/cm³. In certain embodiments, the tap density of the composite material for the secondary lithium-ion battery is 1.2 g/cm³, and the tap density of the porous matrix is 0.5 g/cm³. In certain embodiments, the tap density of the composite material for the secondary lithium-ion battery is 2 g/cm³, and the tap density of the porous matrix is 0.6 g/cm³.

### Electrochemical Performance

In certain embodiments, the electrochemical performance of the composite material disclosed herein is tested in a half-cell. The preparation of the negative electrode sheet is as follows: the composite material of the present application, conductive additive carbon black, and binder (sodium carboxymethyl cellulose and styrene-butadiene rubber in a 1:1 ratio) are weighed in a mass ratio of 95:2:3. Slurry preparation is performed in a slurry mixer at room temperature. The prepared slurry is uniformly coated onto copper foil, dried in a forced-air oven at 50°C for 2 hours, and then cut into electrode sheets with a diameter of 8 mm. The electrode sheets are dried under vacuum in a vacuum oven at 100°C for 10 hours, and then immediately transferred into a glove box for cell assembly. Cell assembly: simulated cells were assembled in a glove box containing a high-purity Ar atmosphere, using metallic lithium as the counter electrode, and a solution of 1M LiPF₆ in ethylene carbonate (EC)/dimethyl carbonate (DMC) (volume ratio v:v=1:1) as the electrolyte. Testing: galvanostatic charge-discharge testing is performed using a battery charge and discharge tester. The discharge cut-off voltage is 0.005V, and the charge cut-off voltage is 1.5V. Charge-discharge testing is conducted at a C/10 current density. The composite material is blended with commercial graphite to form a test material with 450 mAh/g, assembled with lithium cobalt oxide into a coin-type full cell, and cycled at 1C to evaluate its cycling performance.

In certain embodiments, the electrochemical performance of the composite material disclosed herein is tested in a coin-type full cell. The preparation of the positive electrode sheet is as follows: formulation parameters: 96.2% positive electrode material + 1.1% binder + 2.7% conductive agent; processing parameters: dry mixing, high-speed dispersion (solid content 72%), viscosity adjustment to approximately 5000 for coating; coating parameters: single-side areal density of 21 mg/cm². After slitting into 15 cm wide strips, positive electrode sheets sized 73 mm × 44 mm are obtained by die-cutting. The preparation of the negative electrode sheet is as follows: formulation parameters: 95.0 wt% negative electrode material (composite material sample of the example) + 3.5 wt% binder (sodium carboxymethyl cellulose and styrene-butadiene rubber in a 1:1 mass ratio) + 1.5 wt% conductive agent carbon black; processing parameters: dry mixing/kneading (solid content 65%), high-speed dispersion (solid content 45%), viscosity adjustment to approximately 5000 for coating; coating parameters: single-side areal density of 9 mg/cm². After slitting into 15 cm wide strips, negative electrode sheets sized 75 mm × 46 mm are obtained by die-cutting. Cell assembly: proceed as follows: stacking: nine negative electrode sheets and eight positive electrode sheets are stacked in a Z-fold configuration; tab welding: tabs are welded to the positive and negative electrodes (positive: aluminum; negative: nickel); hot pressing and cold pressing: hot press at 80°C for 1 min, cold press at room temperature for 1 minute; aluminum laminate pouch forming: pocket depth of 3 mm; top and side sealing: heat-sealing temperature of 190°C, heat-sealing time of 6 seconds; baking: held at 95°C for 3 days, with periodic nitrogen purging to maintain an inert atmosphere; moisture content test: approximately 1g each of positive and negative electrode sheets are heated at 120°C to remove water, ensuring moisture content below 200 ppm; electrolyte injection: a solution of 1M LiPF₆ in ethylene carbonate (EC)/dimethyl carbonate (DMC) (volume ratio v:v=1:1) is injected between the positive and negative electrode sheets, with an injection coefficient of 3.5 calculated based on the first charge; primary sealing: heat-sealing temperature of 190°C, heat-sealing time of 3 seconds, under a vacuum of -90 kPa; the assembled battery sample is obtained after undergoing wetting at 45°C for 2 days. Full-cell cycling conditions: 1C/1C; voltage range: 2.8-4.25V.

The composite material for the secondary lithium-ion battery disclosed herein can improve the properties of electrical storage devices. For example, it has been shown to improve the first-cycle Coulombic efficiency, specific charge capacity, and capacity retention of lithium-based secondary batteries.

In a certain embodiment, when the composite material of the present invention is used as an electrode in a lithium-ion battery, the composite material exhibits a first-cycle Coulombic efficiency of 75% or more, or 80% or more, or 82% or more, or 85% or more, or 88% or more, or 90% or more, or 92% or more, or 93% or more, or 95% or more, or 98% or more, or 99% or more.

In a certain embodiment, when the composite material of the present invention is used as an electrode in a lithium-ion battery, the composite material exhibits a specific charge capacity of 1600 mAh/g or more, for example, 1600 mAh/g, 1650 mAh/g, 1680 mAh/g, 1700 mAh/g, 1750 mAh/g, 1800 mAh/g, 1850 mAh/g, 1900 mAh/g, 1950 mAh/g, 2000 mAh/g, 2100 mAh/g, 2200 mAh/g, etc.

In a certain embodiment, when the composite material of the present invention is used as an electrode in a lithium-ion battery, after 15 cycles under operating conditions of 25°C and 1C charge-discharge rate, its capacity retention is 40% or more, or 60% or more, or 80% or more, or 85% or more. In a certain embodiment, when the composite material of the present invention is used as an electrode in a lithium-ion battery, after 20 cycles under operating conditions of 25°C and 1C charge-discharge rate, its capacity retention is 60% or more, or 80% or more, or 85% or more. In a certain embodiment, when the composite material of the present invention is used as an electrode in a lithium-ion battery, after 50 cycles under operating conditions of 25°C and 1C charge-discharge rate, its capacity retention is 80% or more, or 85% or more. In a certain embodiment, when the composite material of the present invention is used as an electrode in a lithium-ion battery, after 1000 cycles under operating conditions of 25°C and 1C charge-discharge rate, its capacity retention is 80% or more, or 85% or more. In a certain embodiment, when the composite material of the present invention is used as an electrode in a lithium-ion battery, after 1200 cycles under operating conditions of 25°C and 1C charge-discharge rate, its capacity retention is 80% or more, or 85% or more.

In some embodiments, in half-cell testing of lithium-ion half-cells prepared from the composite material for the secondary lithium-ion battery of the present invention, the charge curve shows no distinct plateau at 0.4-0.5V, and the characteristic peak intensity in the DQ/DV curve at 0.4-0.5V is relatively low. In certain embodiments, in half-cell testing of lithium-ion half-cells prepared from the composite material for the secondary lithium-ion battery, the charge curve exhibits a plateau at 0.4-0.5V, and the characteristic peak intensity in the DQ/DV curve at 0.4-0.5V is relatively high.

The plateau in the charge curve at 0.4-0.5V, and the corresponding characteristic peak in the DQ/DV curve at 0.4-0.5V, are related to the crystallinity of the hydrogen-containing silicon. A higher content of crystalline silicon results in a more pronounced plateau in the charge curve at 0.4-0.5V and a stronger intensity of the characteristic peak in the DQ/DV curve at 0.4-0.5V.

The composite material for the secondary lithium-ion battery disclosed herein can improve the properties of electrical storage devices. For example, it has been shown to reduce the electrode expansion ratio of lithium-based secondary batteries. The thickness expansion ratio test can be performed as follows: initial thickness calibration: 1. batteries that has completed formation are mounted on fixtures and one full charge-discharge cycle at 0.2C is performed to calibrate their capacity and determine their actual initial discharge capacity; 2. the batteries are then charged at 0.2C for 2.5 hours based on the initial discharge capacity to adjust SOC to 50%; 3. the fixtures are removed and the initial thickness of the batteries at 50% SOC is measured; 4. for pouch cell thickness measurement, a caliper is used to measure the thickness at the center of the cell, and measurements are continued until a relatively stable thickness reading is obtained, which is recorded as T0. Full-charge thickness expansion test: 1. during cycling, the full-charge thickness is measured every 50 cycles for the first 200 cycles, and every 100 cycles after 200 cycles, until the capacity fades to 80%; 2. full charging is performed according to the 0.2C CC 4.25V, 4.25V CV 0.04C procedure; 3. for pouch cell thickness measurement, a caliper is used to measure the thickness at the center of the cell, and measurements are continued until a relatively stable thickness reading is obtained, which is recorded as Tₙ; 4. the thickness expansion at a specific cycle number can be calculated using the formula (Tₙ/T₀₋₁).

In a certain embodiment, when the composite material of the present invention is used as an electrode in a lithium-ion battery, after 1200 cycles under operating conditions of 25°C and 1C charge-discharge rate, its electrode expansion ratio is 15% or less, or 10% or less, or 8% or less, for example, about 5%, about 6%, about 7%, about 8%, about 9%, about 10%, etc.

### Beneficial Effects

In the prior art, silicon nanotechnology still has certain shortcomings: on one hand, nano-silicon is difficult to disperse uniformly and tends to agglomerate, which prevents it from fully utilizing the advantages of nano-silicon; on the other hand, nano-silicon exhibits high reactivity, consuming a large number of lithium ions during the formation process of the solid electrolyte interphase (SEI) film, leading to reduced Coulombic efficiency. Meanwhile, during use, the surface of nano-silicon reacts upon contact with the electrolyte, causing gas generation, which results in battery capacity decay, reduced cycling performance, and even safety issues. Therefore, the application of nano-silicon in secondary lithium-ion batteries still faces significant challenges.

The present invention provides a preparation method and use of a composite material for a secondary lithium-ion battery. Compared with the prior art, in the composite material of the present invention, the porous matrix possesses rich pore structures; and the nano-silicon is hydrogen-containing silicon, which is uniformly dispersed within the internal pores of the porous matrix, with no silicon present on the outer surface layer of the porous matrix. The outermost layer of the material further comprises a dense carbon shell. The present invention uses various silicon-containing precursors and a porous matrix as raw materials, uniformly disperses silicon within the porous matrix, and, by controlling temperature, causes a portion of Si-H bonds to be retained in the silicon, forming hydrogen-containing silicon. Finally, the entire material is subjected to carbon coating to prevent the highly active nano-hydrogen-containing silicon from spontaneous combustion in air, and also to ensure that the material does not directly contact the electrolyte during use, facilitating the formation of a stable SEI film. On one hand, the present invention uniformly disperses hydrogen-containing silicon within the composite material, solving the dispersion problem of silicon and avoiding the volume effects caused by silicon agglomeration during charging and discharging. On the other hand, the Si-H bonds contained in the hydrogen-containing silicon can effectively improve the structural stability of the material during charging and discharging, thereby prolonging the cycle life of a battery.

The preparation method for a composite material for a secondary lithium-ion battery in the present invention is simple and easy to operate, and can be used for batch production.

### Examples

The present invention is further described in detail below through specific examples. It should be understood, however, that these examples are provided solely for the purpose of more detailed illustration and should not be construed as limiting the present invention in any form, i.e., they are not intended to limit the scope of the present invention. Unless otherwise indicated, all instruments, equipment, and reagent materials used herein are commercially available. The porous carbon used in the examples of the present application was prepared according to conventional methods in the art.

### Sample Preparation

**Example 1** A porous carbon having the following parameters was used as the porous matrix: oxygen content of 0.01-0.4 mmol/g, BET specific surface area of 1900-2000 m²/g, particle size distribution with D50 of 5-10 µm and D100 of 20-50 µm, and total pore volume of 0.8-1.0 cm³/g. 12 kg of the porous carbon was placed in a fluidized bed. Nitrogen gas was introduced as a protective gas at a flow rate of 23 L/min. The tube furnace was heated to 405°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 405°C, and acetylene gas was introduced at a flow rate of 15 L/min for a duration of 2 hours. Carbon coating was performed on the material via vapor-phase coating to obtain the composite material sample of Example 1.

**Example 2** A porous carbon having the following parameters was used as the porous matrix: oxygen content of 0.01-0.4 mmol/g, BET specific surface area of 1900-2000 m²/g, particle size distribution with D50 of 5-10 µm and D100 of 20-50 µm, and total pore volume of 0.8-1.0 cm³/g. 12 kg of the porous carbon was placed in a fluidized bed. Nitrogen gas was introduced as a protective gas at a flow rate of 23 L/min. The tube furnace was heated to 420°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 420°C, and acetylene gas was introduced at a flow rate of 15 L/min for a duration of 2 hours. Carbon coating was performed on the material via vapor-phase coating to obtain the composite material sample of Example 2.

**Example 3** A porous carbon having the following parameters was used as the porous matrix: oxygen content of 0.01-0.4 mmol/g, BET specific surface area of 1900-2000 m²/g, particle size distribution with D50 of 5-10 µm and D100 of 20-50 µm, and total pore volume of 0.8-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the material via vapor-phase coating to obtain the composite material sample of Example 3.

**Example 4** A porous carbon having the following parameters was used as the porous matrix: oxygen content of 0.01-0.4 mmol/g, BET specific surface area of 1900-2000 m²/g, particle size distribution with D50 of 5-10 µm and D100 of 20-50 µm, and total pore volume of 0.8-1.0 cm³/g. 12 kg of the porous carbon was placed in a fluidized bed. Nitrogen gas was introduced as a protective gas at a flow rate of 23 L/min. The tube furnace was heated to 480°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 480°C, and acetylene gas was introduced at a flow rate of 15 L/min for a duration of 2 hours. Carbon coating was performed on the material via vapor-phase coating to obtain the composite material sample of Example 4.

**Example 5** A porous carbon having the following parameters was used as the porous matrix: oxygen content of 0.01-0.4 mmol/g, BET specific surface area of 1900-2000 m²/g, particle size distribution with D50 of 5-10 µm and D100 of 20-50 µm, and total pore volume of 0.8-1.0 cm³/g. 12 kg of the porous carbon was placed in a fluidized bed. Nitrogen gas was introduced as a protective gas at a flow rate of 23 L/min. The tube furnace was heated to 500°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 500°C, and acetylene gas was introduced at a flow rate of 15 L/min for a duration of 2 hours. Carbon coating was performed on the material via vapor-phase coating to obtain the composite material sample of Example 5.

**Example 6** A porous carbon having the following parameters was used as the porous matrix: oxygen content of 0.01-0.4 mmol/g, BET specific surface area of 1900-2000 m²/g, particle size distribution with D50 of 5-10 µm and D100 of 20-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 550°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 550°C, and acetylene gas was introduced at a flow rate of 15 L/min for a duration of 2 hours. Carbon coating was performed on the material via vapor-phase coating to obtain the composite material sample of Example 6.

**Example 7** A porous carbon having the following parameters was used as the porous matrix: oxygen content of 0.01-0.4 mmol/g, BET specific surface area of 1900-2000 m²/g, particle size distribution with D50 of 5-10 µm and D100 of 20-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 600°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 600°C, and acetylene gas was introduced at a flow rate of 15 L/min for a duration of 2 hours. Carbon coating was performed on the material via vapor-phase coating to obtain the composite material sample of Example 7.

**Example 8** A porous carbon having the following parameters was used as the porous matrix: oxygen content of 0.01-0.4 mmol/g, BET specific surface area of 1000-1100 m²/g, particle size distribution with D50 of 5-10 µm and D100 of 20-50 µm, and total pore volume of 0.4-0.6 cm³/g. 12 kg of the porous carbon was placed in a fluidized bed. Nitrogen gas was introduced as a protective gas at a flow rate of 23 L/min. The tube furnace was heated to 405°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 405°C, and acetylene gas was introduced at a flow rate of 15 L/min for a duration of 2 hours. Carbon coating was performed on the material via vapor-phase coating to obtain the composite material sample of Example 8.

**Example 9** A porous carbon having the following parameters was used as the porous matrix: oxygen content of 0.01-0.4 mmol/g, BET specific surface area of 1500-1600 m²/g, particle size distribution with D50 of 5-10 µm and D100 of 20-50 µm, and total pore volume of 0.6-0.8 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the material via vapor-phase coating to obtain the composite material sample of Example 9.

**Example 10** A porous carbon having the following parameters was used as the porous matrix: oxygen content of 0.01-0.4 mmol/g, BET specific surface area of 2200-2500 m²/g, particle size distribution with D50 of 5-10 µm and D100 of 20-50 µm, and total pore volume of 1.0-1.2 cm³/g. 12 kg of the porous carbon was placed in a fluidized bed. Nitrogen gas was introduced as a protective gas at a flow rate of 27 L/min. The tube furnace was heated to 450°C at a heating rate of 5°C/min. Then, the silicon-containing gas silane was introduced into the fluidized bed for deposition onto the porous carbon. The silane gas flow rate was 50 L/min, and the deposition time was 4 hours. After deposition was completed, the reaction temperature was maintained at 450°C, and acetylene gas was introduced at a flow rate of 15 L/min for a duration of 2 hours. Carbon coating was performed on the material via vapor-phase coating to obtain the composite material sample of Example 10.

**Example 11** A porous carbon having the following parameters was used as the porous matrix: oxygen content of 0.01-0.4 mmol/g, BET specific surface area of 1900-2000 m²/g, particle size distribution with D50 of 1-5 µm and D100 of 10-20 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the material via vapor-phase coating to obtain the composite material sample of Example 11.

**Example 12** A porous carbon having the following parameters was used as the porous matrix: oxygen content of 0.01-0.4 mmol/g, BET specific surface area of 1900-2000 m²/g, particle size distribution with D50 of 10-12 µm and D100 of 15-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the above composite material via vapor-phase coating to obtain the composite material sample of Example 12.

**Example 13** A porous carbon having the following parameters was used as the porous matrix: oxygen content of 0.01-0.4 mmol/g, BET specific surface area of 1900-2000 m²/g, particle size distribution with D50 of 12-15 µm and D100 of 20-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the above composite material via vapor-phase coating to obtain the composite material sample of Example 13.

**Example 14** A porous carbon having the following parameters was used as the porous matrix: oxygen content of 0.01-0.4 mmol/g, BET specific surface area of 1900-2000 m²/g, particle size distribution with D50 of 15-20 µm and D100 of 25-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the above composite material via vapor-phase coating to obtain the composite material sample of Example 14.

**Example 15** A porous carbon having the following parameters was used as the porous matrix: oxygen content of 0.1-0.3 mmol/g, BET specific surface area of 1900-2000 m²/g, particle size distribution with D50 of 5-10 µm and D100 of 20-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the above composite material via vapor-phase coating to obtain the composite material sample of Example 15.

**Example 16** A porous carbon having the following parameters was used as the porous matrix: oxygen content of 0.2-0.5 mmol/g, BET specific surface area of 1900-2000 m²/g, particle size distribution with D50 of 5-10 µm and D100 of 20-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the above composite material via vapor-phase coating to obtain the composite material sample of Example 16.

**Example 17** A porous carbon having the following parameters was used as the porous matrix: oxygen content of 0.3-0.6 mmol/g, BET specific surface area of 1900-2000 m²/g, particle size distribution with D50 of 5-10 µm and D100 of 20-50 µm, and total pore volume of 0.9-1.0 cm³/g. 12 kg of the porous carbon was placed in a fluidized bed. Nitrogen gas was introduced as a protective gas at a flow rate of 23 L/min. The tube furnace was heated to 450°C at a heating rate of 5°C/min. Then, the silicon-containing gas silane was introduced into the fluidized bed for deposition onto the porous carbon. The silane gas flow rate was 35 L/min, and the deposition time was 6 hours. After deposition was completed, the reaction temperature was maintained at 450°C, and acetylene gas was introduced at a flow rate of 15 L/min for a duration of 2 hours. Carbon coating was performed on the above composite material via vapor-phase coating to obtain the composite material sample of Example 17.

### Performance Testing

**Infrared Spectroscopy:** The composite material sample powder from the example was uniformly mixed with potassium bromide powder and then pressed into a pellet under a pressure of 8-10 MPa for 1 minute. The prepared pellet sample was placed in a Fourier Transform Infrared (FTIR) spectrometer for testing. The characteristic infrared absorption features corresponding to the silicon-hydrogen bonding mode generally appear in three regions of the infrared absorption spectrum: (I) the wagging mode region at 500-800 cm⁻¹, (II) the bending mode region at 800-1000 cm⁻¹, and (III) the stretching mode region at 1850-2250 cm⁻¹. Characteristic peak I exhibits a strong signal, while the latter two characteristic absorption peaks are related to the preparation conditions. The hydrogen content can be determined by the wagging mode calculation method. The absorption peak at 630 cm⁻¹ was subjected to Gaussian fitting, and the integrated area of the fitting function was used to determine the hydrogen content C_{H} in the hydrogen-containing silicon within the composite material. The specific data are provided in Table 1 below.

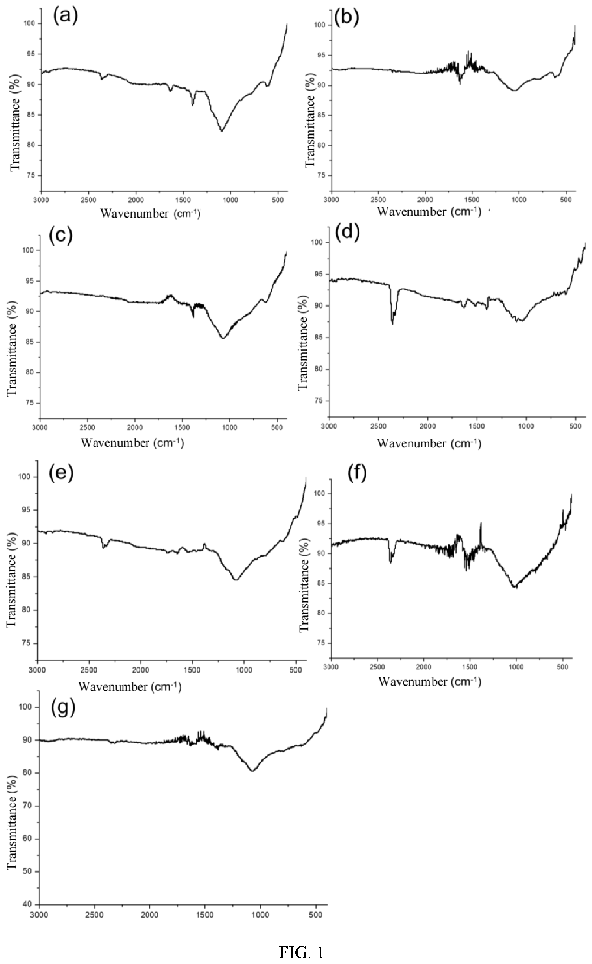

FIGs. 1(a)-(g) respectively show the infrared spectra of the composite material samples of Examples 1-7. As shown in FIG. 1(a), in the infrared spectrum of the Example 1 sample, the absorption peak near 630 cm⁻¹ is attributed to the wagging vibration absorption of the silicon-hydrogen bond; the absorption peak near 1050 cm⁻¹ is attributed to the stretching vibration absorption of the carbon-oxygen bond; the absorption peak near 1384 cm⁻¹ is attributed to the stretching vibration absorption of the carbon-hydrogen bond; the absorption peak near 1630 cm⁻¹ is attributed to the stretching vibration absorption of the carbon-carbon bond; and the absorption peak near 2370 cm⁻¹ is attributed to the asymmetric stretching vibration absorption of the carbon-oxygen bond.

**XRD:** The composite material sample powder from the example was placed in an XRD diffractometer. The scan range was 10-65° with a scan rate of 5°/min to compare the differences between crystalline and amorphous silicon peaks. Crystallite size could also be fitted. Copper target X-rays with a wavelength of 0.154 nm were used.

**SEM:** It was used to characterize the surface morphology of the composite material, observing surface roughness to assist in judging the deposition status of surface silicon.

**TEM:** An electron beam emitted from the electron gun travels along the optical axis of the column in a vacuum channel through the condenser lens, which converges it into a fine, bright, and uniform spot, illuminating the sample in the sample chamber. The electron beam transmitted through the sample carries information about the internal structure of the sample; denser regions of the sample transmit fewer electrons, while less dense regions transmit more electrons. After being converged, focused, and primarily magnified by the objective lens, the electron beam enters subsequent intermediate lenses and the first and second projector lenses for comprehensive magnification and imaging. Finally, the magnified electron image is projected onto the fluorescent screen in the viewing chamber. The composite material powder was uniformly dispersed in ethanol, a small amount was dropped onto a copper grid, and after drying, it was loaded into the instrument. TEM was used to observe the size of silicon crystalline domains within the composite material.

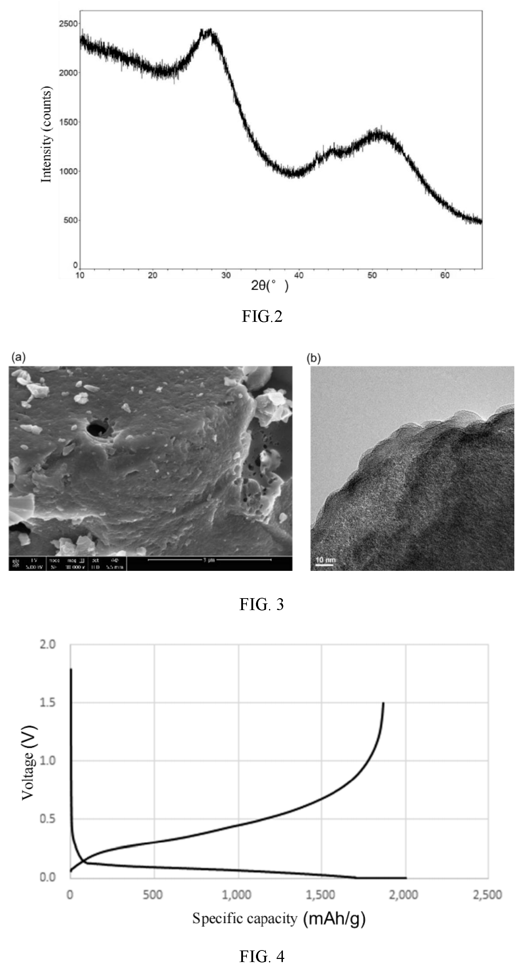

The XRD pattern of the composite material sample of Example 1 is shown in FIG. 2. According to FIG. 2, the hydrogen-containing silicon deposited at this temperature was in an amorphous state. The peak profile was broad between diffraction angles of 20-30°, and no sharp diffraction response peak attributable to the (111) plane of crystalline silicon was found near 28.4°.

FIG. 3(a) shows the SEM image of the composite material sample of Example 1. FIG. 3 (b) shows the TEM image of the composite material sample of Example 1. It can be seen from FIG. 3 that the surface of the composite material obtained under these preparation conditions showed no significant difference from the surface of the porous carbon matrix without silicon deposition, presenting a uniformly rough morphology, and no particulate nano-silicon deposition was observed. Characterization of the near-surface region of the material by TEM revealed no distinct diffraction fringes attributable to crystalline Si, demonstrating that the hydrogen-containing silicon deposited at this temperature was in an amorphous state.

Based on the XRD, SEM, and TEM test results, the deposited hydrogen-containing silicon in all samples from the examples was in an amorphous state.

**Elemental Analysis**: For the composite material samples of the examples, the C content was measured using a carbon-sulfur analyzer, the O content was measured using a nitrogen-oxygen analyzer, the hydrogen content C_{H} in the hydrogen-containing silicon was calculated by fitting the infrared absorption peak in the wagging mode region, and the content of components other than C, O, and H was taken as the Si content in the composite material sample. The specific data are shown in Table 1 below.

### Electrical Performance Test

### Half-Cell:

The negative electrode sheets were prepared using the composite material samples from the examples, and coin-type half-cells were assembled for testing, as detailed below:
The preparation of the negative electrode sheet: the composite material from the example, conductive additive carbon black, and binder (sodium carboxymethyl cellulose and styrene-butadiene rubber in a mass ratio of 1:1) were weighed in a mass ratio of 95:2:3. Slurry preparation was performed in a slurry mixer at room temperature. The prepared slurry was uniformly coated onto copper foil, dried in a forced-air oven at 50°C for 2 hours, and then cut into electrode sheets with a diameter of 8 mm. The electrode sheets were dried under vacuum in a vacuum oven at 100°C for 10 hours, and then immediately transferred into a glove box for cell assembly.

Cell assembly: simulated cells were assembled in a glove box containing a high-purity Ar atmosphere. Metallic lithium was used as the counter electrode, and a solution of 1 M LiPF₆ in ethylene carbonate (EC) / dimethyl carbonate (DMC) (volume ratio v:v = 1:1) was used as the electrolyte to assemble the cells.

Half-Cell Testing: galvanostatic charge-discharge testing was performed using a battery charge and discharge tester. The discharge cut-off voltage was 0.005V, and the charge cut-off voltage was 1.5V. Charge-discharge testing was conducted at a C/10 current density. The relevant test data obtained (specific charge capacity, first-cycle Coulombic efficiency, etc.) are provided in Table 1.

FIG. 4 shows the charge-discharge curve of a coin-type half-cell assembled using the negative electrode sheet prepared from the composite material sample of Example 1. The first discharge (lithiation) curve exhibited three plateaus at 0.3-0.5V, 0.1-0.3V, and 0-0.1V, corresponding to three lithiation peaks in the DQ/DV curve. Among these, the lithiation peak at 0.3-0.5V was related to the microporous structure and oxygen content of the porous carbon matrix; the lithiation peak at 0.1-0.3V corresponded to the phase transition from Si to the Li_{2.0}Si alloy state; and the lithiation peak at 0-0.1V corresponded to the phase transition from the Li_{2.0}Si alloy state to the Li_{3.5}Si alloy state. The first charge (delithiation) curve exhibited three plateaus at 0.2-0.4V, 0.4-0.6V, and 0.6-0.8V, corresponding to three delithiation peaks in the DQ/DV curve. Among these, the delithiation peak at 0.2-0.4V corresponded to the phase transition from the Li_{3.5}Si alloy state to the Li_{2.0}Si alloy state; the delithiation peak at 0.4-0.6V corresponded to the phase transition from the Li_{2.0}Si alloy state to Si; and the delithiation peak at 0.6-0.8V was related to the microporous structure and oxygen content of the porous carbon matrix. In the DQ/DV curves of some other examples, a sharp delithiation peak between 0.4-0.5V was also present. The intensity of this peak correlated with the content of crystalline silicon; the higher the crystalline silicon content, the greater the peak intensity.

### Full-cell:

Referring to the preparation and testing process for the half-cell described above, the negative electrode sheets were prepared using the composite material samples from the examples as the negative electrode material, and full-cells were assembled for testing, as detailed below:
The preparation of the positive electrode sheet: formulation parameters: 96.2 wt% LiNi_{0.6}Co_{0.2}Mn_{0.2}O₂(622 positive electrode material) + 1.1 wt% PVDF (binder) + 2.7 wt% Super P (conductive agent); processing parameters: dry mixing, high-speed dispersion (solid content 72%), viscosity adjustment to approximately 5000 cP for coating; coating parameters: single-side areal density of 21 mg/cm². After slitting into 15 cm wide strips, positive electrode sheets sized 73 mm × 44 mm were obtained by die-cutting.

The preparation of the negative electrode sheet: formulation parameters: 95.0 wt% negative electrode material (composite material sample of the example) + 3.5 wt% binder (sodium carboxymethyl cellulose and styrene-butadiene rubber in a 1:1 mass ratio) + 1.5 wt% conductive agent carbon black; processing parameters: dry mixing and kneading (solid content 65%), high-speed dispersion (solid content 45%), viscosity adjustment to approximately 5000 for coating; coating parameters: single-side areal density of 9 mg/cm². After slitting into 15 cm wide strips, negative electrode sheets sized 75 mm × 46 mm were obtained by die-cutting.

Cell assembly was proceeded as follows: stacking: nine negative electrode sheets and eight positive electrode sheets were stacked in a Z-fold configuration; tab welding: tabs were welded to the positive and negative electrodes (positive: aluminum; negative: nickel); hot pressing and cold pressing: hot pressing was performed at 80°C for 1 min, cold pressing was performed at room temperature for 1 minute; aluminum laminate pouch forming: pocket depth of 3 mm; top and side sealing: heat-sealing temperature of 190°C, heat-sealing time of 6 seconds; baking: held at 95°C for 3 days, with periodic nitrogen purging to maintain an inert atmosphere; moisture content test: approximately 1g each of positive and negative electrode sheets were heated at 120°C to remove water, ensuring moisture content below 200 ppm; electrolyte injection: a solution of 1M LiPF₆ in ethylene carbonate (EC)/dimethyl carbonate (DMC) (volume ratio v:v=1:1) was used as the electrolyte and it was injected between the positive and negative electrode sheets, with an injection coefficient of 3.5 calculated based on the first charge; primary sealing: heat-sealing temperature of 190°C, heat-sealing time of 3 seconds, under a vacuum of -90 kPa; the assembled battery sample was obtained after undergoing wetting at 45°C for 2 days.

Full-cell testing: cycling conditions: 1C/1C; voltage range: 2.8-4.25V.

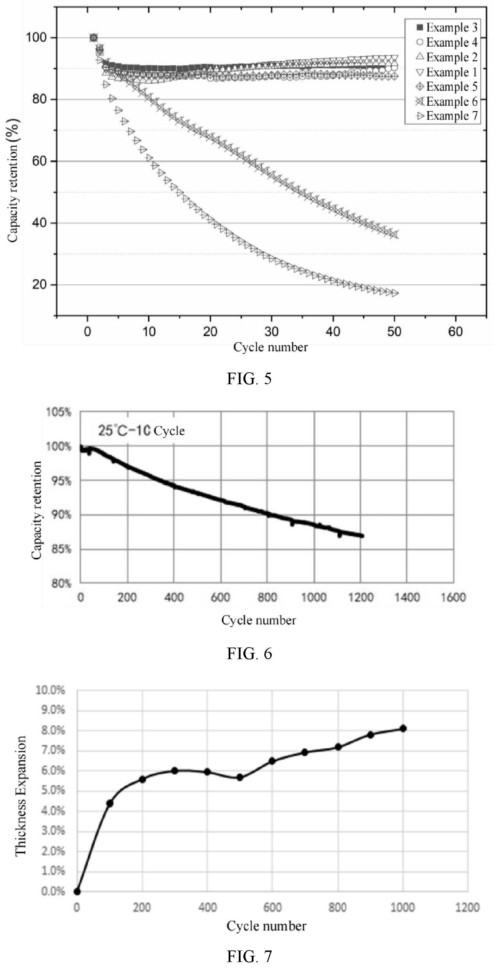

FIG. 5 shows the cycling curves (cycle number: 50 cycles) for the coin-type full-cells of Examples 1-7. FIG. 6 shows the cycling curve (cycle number: 1200 cycles) for the coin-type full-cell of Example 1.

### Thickness Expansion Ratio Test:

Initial thickness calibration: 1. batteries that had completed formation were mounted on fixtures and one full charge-discharge cycle at 0.2C was performed to calibrate their capacity and determine their actual initial discharge capacity; 2. the batteries were then charged at 0.2C for 2.5 hours based on the initial discharge capacity to adjust SOC to 50%; 3. the fixtures were removed and the initial thickness of the batteries at 50% SOC was measured; 4. for pouch cell thickness measurement, a caliper was used to measure the thickness at the center of the cell, and measurements were continued until a relatively stable thickness reading was obtained, which was recorded as T0.

Full-charge thickness expansion test: 1. during cycling, the full-charge thickness was measured every 50 cycles for the first 200 cycles, and every 100 cycles after 200 cycles, until the capacity faded to 80%; 2. full charging was performed according to the 0.2C CC 4.25V, 4.25V CV 0.04C procedure; 3. for pouch cell thickness measurement, a caliper was used to measure the thickness at the center of the cell, and measurements were continued until a relatively stable thickness reading was obtained, which was recorded as Tₙ; 4. the thickness expansion at a specific cycle number was calculated using the formula (Tₙ/T₀₋₁).

FIG. 7 shows the thickness expansion curve of the coin-type full-cell of Example 1.

**Table 1**

| **Example** | **Elemental content of the composite material samples** | | | | **BET (m²/g)** | **Particle size distribution** | | **Electrochemical performance** | |
|---|---|---|---|---|---|---|---|---|---|
| | **C Content (wt%)** | **Si Content (wt%)** | **O Content (wt%)** | **H Content * (wt%)** | | **D50 (µm)** | **D100 (µm)** | **Specific charge capacity (mAh/g)** | **first-cycle Coulombic efficiency (%)** |
| **1** | 51.8 | 45.00 | 0.20 | 3.00 | 5 | 5-15 | 20-60 | 1864±10 | 93.2±0.5 |
| **2** | 51.3 | 46.10 | 0.20 | 2.40 | 5 | 5-15 | 20-60 | 1911±10 | 92.9±0.5 |
| **3** | 50.8 | 47.20 | 0.20 | 1.80 | 5 | 5-15 | 20-60 | 1953±10 | 93.2±0.5 |
| **4** | 50.2 | 47.90 | 0.10 | 1.80 | 5 | 5-15 | 20-60 | 1993±10 | 93.1±0.5 |
| **5** | 50.2 | 48.80 | 0.10 | 0.90 | 5 | 5-15 | 20-60 | 2032±10 | 93.0±0.5 |
| **6** | 49.4 | 50.20 | 0.10 | 0.30 | 5 | 5-15 | 20-60 | 2073±10 | 93.8±0.5 |
| **7** | 49.6 | 50.30 | 0.10 | 0.01 | 5 | 5-15 | 20-60 | 2075±10 | 93.5±0.5 |
| **8** | 54.2 | 42.80 | 0.30 | 2.70 | 5 | 5-15 | 20-60 | 1786±10 | 93.1±0.5 |
| **9** | 52.8 | 45.10 | 0.30 | 1.80 | 5 | 5-15 | 20-60 | 1866±10 | 93.3±0.5 |
| **10** | 43.9 | 54.40 | 0.20 | 1.50 | 5 | 5-15 | 20-60 | 2240±10 | 93.6±0.5 |
| **11** | 49.8 | 48.20 | 0.20 | 1.80 | 5 | 1-15 | 10-30 | 1973±10 | 93.2±0.5 |
| **12** | 51.7 | 46.30 | 0.20 | 1.80 | 5 | 5-15 | 20-60 | 1912±10 | 92.9±0.5 |
| **13** | 53.0 | 45.30 | 0.20 | 1.50 | 5 | 12-20 | 20-60 | 1869±10 | 92.7±0.5 |
| **14** | 54.6 | 43.90 | 0.30 | 1.20 | 5 | 15-30 | 20-60 | 1823±10 | 92.2±0.5 |
| **15** | 50.1 | 47.40 | 1.00 | 1.50 | 5 | 5-15 | 20-60 | 1946±10 | 91.0±0.5 |
| **16** | 49.1 | 48.20 | 1.50 | 1.20 | 5 | 5-15 | 20-60 | 1989±10 | 89.9±0.5 |
| **17** | 50.5 | 46.60 | 2.00 | 0.90 | 5 | 5-15 | 20-60 | 1905±10 | 87.0±0.5 |

| | | | | | | | | | |
|---|---|---|---|---|---|---|---|---|---|
| H content *: hydrogen content C_{H} in the hydrogen-containing silicon. | | | | | | | | | |

As shown in FIG. 5, coin-type full cells prepared by using the composite materials of Examples 1-7 of the present application exhibited excellent long-term cycling capacity retention. When cycled under operating conditions of 25°C and a 1C charge-discharge rate for 15 cycles, their capacity retention was all above 40%. It can be seen from FIG. 5 that the capacity retention exhibited a positive correlation with the hydrogen content in the hydrogen-containing silicon within the composite material. The hydrogen content in the hydrogen-containing silicon of the composite material sample of Example 6 increased to 0.03 wt%. The coin-type full cell prepared from the sample of Example 6 maintained a capacity retention above 60% after 20 cycles under operating conditions of 25°C and a 1C charge-discharge rate. For the composite material samples of Examples 1-5, where the hydrogen content in the hydrogen-containing silicon was above 0.09%, the coin-type full cells prepared therefrom exhibited significantly superior long-term cycling capacity retention. After 50 cycles under operating conditions of 25°C and a 1C charge-discharge rate, their capacity retention was all above 80%.

The full cell prepared using the composite material of Example 1 demonstrated exceptionally outstanding long-term cycling capacity retention. After 1200 cycles under operating conditions of 25°C and a 1C charge-discharge rate, its capacity retention reached 87%, far exceeding the requirement of 80% capacity retention after 1000 cycles for power batteries. Regarding electrode expansion, the coin-type full cell of Example 1 exhibited an expansion ratio of merely 8% after 1000 cycles.

In the composite material samples of Examples 3 and 8-10, apart from the silicon content, the contents of all other elements, BET specific surface area, and particle size distribution were very similar. As shown in Table 2, with increasing silicon content of the composite material samples, the specific charge capacity of the samples showed an upward trend.

As can be seen from the preparation processes of Examples 8-10, the silicon content of the composite material samples exhibited a positive correlation with the pore volume (e.g., as indicated by BET test results) of the porous carbon matrix. As can be seen from the preparation processes of Examples 11-14 that the silicon content of the composite material samples exhibited a negative correlation with the particle size (e.g., D50 particle size) of the porous carbon matrix.

In the samples of Example 1 and Examples 15-17, apart from the oxygen content, the contents of all other elements, BET specific surface area, and particle size distribution were very similar. As shown in Table 2, with increasing oxygen content of the composite material samples, the first-cycle Coulombic efficiency of the samples showed a gradual decline.

It can be seen from the test data in Table 1 and FIG. 5 that batteries assembled with the composite materials for secondary lithium-ion batteries according to the examples of the present invention exhibited higher specific charge capacity and first-cycle Coulombic efficiency than commercially available negative electrodes, along with significantly improved cycling performance.

In the composite material of the present invention, the porous matrix possesses rich pore structures, and the nano-silicon is hydrogen-containing silicon, which is uniformly dispersed within the internal pores of the porous matrix, with no silicon present on the outer surface layer of the porous matrix; furthermore, the outermost layer of the material comprises a dense shell layer. The present invention uses various silicon-containing precursors and a porous matrix as raw materials, uniformly disperses silicon within the porous matrix, and, by controlling temperature, causes a portion of Si-H bonds to be retained in the silicon, forming hydrogen-containing silicon. Finally, the entire material is subjected to coating to prevent the highly active nano-hydrogen-containing silicon from spontaneous combustion in air, and also to ensure that the material does not directly contact the electrolyte during use, facilitating the formation of a stable SEI film.

On one hand, the present invention uniformly disperses hydrogen-containing silicon within the porous matrix, solving the dispersion problem of silicon and avoiding the volume effects caused by silicon agglomeration during charging and discharging; on the other hand, the Si-H bonds contained in the hydrogen-containing silicon can effectively improve the structural stability of the material during charging and discharging, thereby prolonging the cycle life of a battery.

It will be apparent to those skilled in the art that many modifications and variations of the present invention can be made without departing from its spirit and scope. The specific embodiments described herein are provided by way of example only and are not intended to be limiting in any manner. The true scope and spirit of the present invention are indicated by the appended claims, and the specification and examples are illustrative only.

## Claims

1. A composite material for a secondary lithium-ion battery, wherein the composite material comprises: a porous matrix, hydrogen-containing silicon dispersed within the porous matrix, and a shell layer coating the outer surface of the porous matrix.

2. The composite material according to claim 1, wherein in the composite material, based on the total weight of the composite material, the hydrogen content in the hydrogen-containing silicon is 0.01-10 wt%, preferably 0.3-5 wt%, more preferably 0.9-3 wt%.

3. The composite material according to claim 1, wherein
based on the total weight of the composite material, the silicon content of the composite material is 5-90 wt%, preferably 15-70 wt%, more preferably 30-65 wt%; and/or
based on the total weight of the composite material, the carbon content of the composite material is 10-95 wt%, preferably 30-90 wt%, more preferably 35-85 wt%; and/or
based on the total weight of the composite material, the oxygen content of the composite material is 0-3 wt%.

4. The composite material according to claim 1, wherein
the tap density of the composite material is 0.5-2 g/cm³; and/or
the tap density of the porous matrix is 0.2-0.6 g/cm³.

5. The composite material according to claim 1, wherein the infrared spectrum of the composite material has a vibration peak at 625-640 cm⁻¹.

6. The composite material according to claim 5, wherein the infrared spectrum of the composite material further has vibration peaks at one or more of the following positions: 845-885 cm⁻¹, 1990-2010 cm⁻¹.

7. The composite material according to claim 1, wherein the particle size of the hydrogen-containing silicon is in the range of 0.1-60 nm, preferably 0.1-20 nm, more preferably 1-5 nm.

8. The composite material according to claim 1, wherein the composite material has one or more of the following characteristics:
a BET specific surface area of 10 m²/g or less;
a total pore volume of 0.1 cm³/g or less;
a D50 particle size of 1-50 µm;
a D100 particle size of 10-100 µm.

9. The composite material according to claim 1, wherein the porous matrix has one or more of the following characteristics:
an oxygen content of 0.01-0.6 mmol/g;
comprising 20%-90% micropores, 10%-50% mesopores, and 0-30% macropores;
a BET specific surface area of 1000-2500 m²/g ;
a total pore volume of 0.1-2.5 cm³/g , preferably 0.5-1.2 cm³/g;
a D50 particle size of 1-30 µm, preferably 1-20 µm;
a D100 particle size of 5-80 µm, preferably 5-50 µm.

10. The composite material according to claim 1, wherein the porous matrix comprises: porous carbon, a porous polymeric material, a porous ceramic material, a porous metallic material, or a combination thereof.

11. The composite material according to claim 1, wherein the component of the shell layer comprises: amorphous carbon, graphene, carbon nanotubes, conductive polymers, titanium carbide, aluminum oxide, aluminum nitride, a carbide of silicon, a nitride of silicon, an oxide of silicon, an oxynitride of silicon, or a combination thereof.

12. The composite material according to claim 1, wherein the thickness of the shell layer is 1-1000 nm.

13. The composite material according to claim 1, wherein
in the electrochemical charging curve of a half-cell prepared from the composite material, a plateau is present at 0.4-0.5 V, and/or
in the DQ/DV curve of a half-cell prepared from the composite material, a characteristic peak is present at 0.4-0.5 V.

14. A method for preparing the composite material according to any one of claims 1-13, comprising the steps of:
providing a porous matrix;
forming hydrogen-containing silicon dispersed within the porous matrix by a CVD deposition process and/or a liquid impregnation process; and
coating the outer surface of the porous matrix having the hydrogen-containing silicon dispersed therein to form a shell layer.

15. The method according to claim 14, wherein forming hydrogen-containing silicon dispersed within the porous matrix by the CVD deposition process includes:
placing the porous matrix in a reaction vessel, and introducing a protective gas into the reaction vessel;
heating the reaction vessel to a reaction temperature; and
introducing a silicon-containing gas into the reaction vessel for deposition within the porous matrix;
preferably,
the heating rate for the reaction vessel is 1-10°C/min;
the reaction temperature is 400-600°C;
the flow rate of the protective gas is 5-30 L/min;
the total flow rate of the silicon-containing gas is 10-40 L/min;
the deposition time is 5-20 hours.

16. The method according to claim 15, wherein
the silicon-containing gas comprises: dichlorosilane, SiₙH₂ₙ₊₂ silane, or a combination thereof, wherein n is an integer selected from 1-3;
preferably, the silicon-containing gas comprises: dichlorosilane, monosilane, disilane, trisilane, or a combination thereof.

17. The method according to claim 14, wherein forming the hydrogen-containing silicon dispersed within the porous matrix by the liquid impregnation process includes:
uniformly mixing the porous matrix and a silane liquid,
performing carbonization and reduction by high temperature.

18. The method according to claim 17, wherein the silane liquid comprises: trichlorosilane, SiₙH₂ₙ₊₂ silane, or a combination thereof, wherein n is an integer selected from 4-10.

19. The method according to claim 14, wherein coating the outer surface of the porous matrix having the hydrogen-containing silicon dispersed therein to form a shell layer is perfomed by reactive coating, adhesive coating or a combination thereof.

20. A negative electrode sheet, wherein the negative electrode sheet comprises the composite material according to any one of claims 1-13.

21. A lithium-ion secondary battery, wherein the lithium-ion battery comprises the negative electrode sheet according to claim 20.
